(19) Europäisches Patentamt
European Patent Office
Office européen des brevets

(11) EP 4 775 328 A1

(12) EUROPEAN PATENT APPLICATION
published in accordance with Art. 153(4) EPC

(43) Date of publication:
**15.07.2026 Bulletin 2026/29**

(21) Application number: **24862799.4**

(22) Date of filing: **03.09.2024**

(51) International Patent Classification (IPC):
***B22F 1/00*** (2022.01) ***B22F 1/052*** (2022.01)
***B22F 7/08*** (2006.01) ***B22F 9/00*** (2006.01)
***C22C 5/06*** (2006.01) ***H01L 21/52*** (2006.01)

(52) Cooperative Patent Classification (CPC):
**B22F 1/00; B22F 1/052; B22F 7/08; B22F 9/00; C22C 5/06; H10W 72/071**

(86) International application number:
**PCT/JP2024/031633**

(87) International publication number:
**WO 2025/053147 (13.03.2025 Gazette 2025/11)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **08.09.2023 JP 2023146495**

(71) Applicants:
- **Daicel Corporation**
  **Osaka-shi, Osaka 530-0011 (JP)**
- **The University of Osaka**
  **Osaka 565-0871 (JP)**

(72) Inventors:
- **SAKAMOTO, Takeshi**
  **Tokyo 108-8230 (JP)**
- **UESHIMA, Minoru**
  **Tokyo 108-8230 (JP)**
- **CHEN, Chuantong**
  **Suita-shi, Osaka 565-0871 (JP)**
- **NAKAYAMA, Koji**
  **Suita-shi, Osaka 565-0871 (JP)**
- **NAOE, Takuya**
  **Suita-shi, Osaka 565-0871 (JP)**

(74) Representative: **Grünecker Patent- und Rechtsanwälte
PartG mbB
Leopoldstraße 4
80802 München (DE)**

# (54) ALLOY POWDER, ALLOY PASTE, AND SEMICONDUCTOR DEVICE

(57) Provided is an alloy powder that can form a bonding layer that operates at high temperatures and exhibits excellent bonding reliability while complying with environmental regulations. An alloy powder of the present disclosure is characterized by having an AgSi eutectic structure, in which the proportion of the AgSi eutectic structure is 10% or more in at least 8 or more of 10 particles when any 10 adjacent particles of the alloy powder are subjected to a method including selecting one particle from an image of a particle cross section, the image being captured by SEM at a magnification of from 2000 to 50000 times, measuring a total outer peripheral length of the particle and a length of an outer peripheral portion where the eutectic structure is present, a region where no eutectic structure is present in a region from the outer periphery to 0.2 μm in a direction toward the center of the particle being excluded from the outer peripheral portion, and calculating a proportion of the length of the outer peripheral portion thereof to the total outer peripheral length as the proportion of the AgSi structure on the particle surface.

EP 4 775 328 A1

## Description

### Technical Field

The present disclosure relates to an alloy powder, an alloy paste, and a semiconductor device. Moreover, the present application claims the rights of priority on the basis of Japanese Patent Application No. 2023-146495 filed in Japan on September 8, 2023, the content of which is incorporated herein by reference.

### Background Art

Semiconductors used in power devices are required to exhibit high efficiency, minimal loss, and high frequency switching, and the use of SiC and GaN semiconductors, which are wide bandgap semiconductors, is expanding. In such a semiconductor, the operating temperature may exceed 200°C, and thus the bonding material used for bonding is required to maintain high bonding reliability even when the semiconductor is operated at high temperatures or in a harsh temperature cycle environment.

In addition, solder has been used as a high-temperature resistant bonding material in the related art, but lead-free materials are now required due to stricter environmental regulations and safety requirements. As such lead-free materials that can be used as alternatives to solder, the materials disclosed in Patent Documents 1 to 3, for example, are known.

### Citation List

### Patent Document

Patent Document 1: JP 2003-311469 A
Patent Document 2: JP 2020-069517 A
Patent Document 3: JP 2019-56158 A

### Summary of Invention

### Technical Problem

However, the lead-free solder disclosed in Patent Document 1 has a low melting point and is particularly problematic in that the Sn not converted into a metal compound in the solder melts at about 230°C.

In addition, in the lead-free solder disclosed in Patent Document 2, bismuth (Bi) is used to achieve a high melting point, and while a high melting point can be achieved, this lead-free solder is also problematic in that cracks extend due to repeated heating, resulting in a problem with connection reliability.

In addition, while the silver (Ag) paste disclosed in Patent Document 3 does not melt in a usage environment of around 250°C, repeated heating causes coarsening of the metal structure and an aggregation of voids, resulting in a problem with bonding reliability.

The present disclosure solves the above problems, and an object thereof is to provide an alloy powder that can form a bonding layer that operates at high temperatures and is excellent in bonding reliability while complying with environmental regulations.

### Solution to Problem

As a result of intensive efforts to solve the above problems, the inventors of the present disclosure discovered that an alloy powder having an AgSi eutectic structure with the AgSi eutectic structure being present on the surface of the alloy powder at a specific proportion is operable at high temperatures and exhibits excellent bonding reliability while complying with environmental regulations.

That is, the present disclosure provides an alloy powder having an AgSi eutectic structure, and the proportion of the AgSi eutectic structure is 10% or more in at least 8 or more of 10 particles when any 10 adjacent particles of the alloy powder are subjected to a method including selecting one particle from an image of a particle cross-section, the image being captured by SEM at a magnification of from 2000 to 50000 times of a particle cross section using a scanning electron microscope (SEM), measuring a total outer peripheral length of the particle and a length of an outer peripheral portion where the eutectic structure is present, a region where no eutectic structure is present in a region from the outer periphery to a depth of 0.2 μm in a direction toward the center of the particle being excluded from the outer peripheral portion, and calculating a proportion of the length of the outer peripheral portion thereof to the total outer peripheral length as the proportion of the AgSi structure on the particle surface.

When the AgSi eutectic structure is present and the proportion thereof is 10% or more, silver (Ag) in the AgSi eutectic structure present on the surface can be recrystallized by heating during sinter bonding and can thus be exuded from the surface of the alloy powder, and the linear expansion coefficient of the alloy powder itself can be reduced while the alloy powder is firmly bonded to an adherend, and therefore bonding reliability is excellent. Furthermore, since silver (Ag) and silicon (Si) are used as raw materials, the alloy powder is also compliant with environmental regulations.

The alloy powder preferably has an average particle size (median diameter) of from 0.1 to 100 μm.

Relative to the total amount of the alloy powder, the content of silver (Ag) is preferably from 15 to 97.6 mass%, and the content of silicon (Si) is preferably from 2.4 to 85 mass%. When the contents of silver (Ag) and silicon (Si) are within the above ranges, the AgSi eutectic structure is easily localized on the surface of the alloy powder at a sufficient proportion while the linear expansion coefficient is suppressed.

The present disclosure also provides an alloy paste containing the alloy powder.

The alloy paste preferably further contains an organic substance.

The alloy paste further contains a silver (Ag) powder, and the content of the silver (Ag) powder is preferably from 5 to 2000 parts by mass per 100 parts by mass of the alloy powder.

The present disclosure also provides a semiconductor device in which the alloy paste is used.

## Advantageous Effects of Invention

According to the alloy powder of the present disclosure, a bonding layer that operates at high temperatures and exhibits excellent bonding reliability while complying with environmental regulations can be provided. Therefore, a semiconductor device obtained using the alloy powder-containing alloy paste of the present disclosure can operate at high temperatures and exhibit excellent bonding reliability while complying with environmental regulations.

## Brief Description of Drawings

FIG. 1 is a SEM image of a cross-section of an alloy powder of the present disclosure.
FIG. 2 is a SEM image of a cross-section of an alloy powder of the present disclosure.
FIG. 3 is a cross-sectional view schematically illustrating an example of a semiconductor device according to an embodiment of the present disclosure.

## Description of Embodiments

### Alloy Powder

An alloy powder according to an embodiment of the present disclosure has an AgSi eutectic structure, and the proportion of the AgSi eutectic structure is 10% or more in at least 8 or more of 10 particles when any 10 adjacent particles of the alloy powder are subjected to a method including selecting one particle from an image of a particle cross section, the image being captured by SEM at a magnification of from 2000 to 50000 times, measuring a total outer peripheral length of the particle and a length of an outer peripheral portion where the eutectic structure is present, a region where no eutectic structure is present in a region from the outer periphery to a depth of 0.2 μm in a direction toward the center of the particle being excluded from the outer peripheral portion, and calculating a proportion of the length of the outer peripheral portion thereof to the total outer peripheral length as the proportion of the AgSi structure on the particle surface. As the alloy powder, one type may be used alone, or two or more types thereof may be used in combination.

FIGS. 1 and 2 are enlarged SEM images of cross sections of particles of the alloy powder. The black portions in the images are regions made of silicon (Si), and the white portions are regions made of an AgSi eutectic structure in which silicon (Si) is dispersed in Ag.

In the present disclosure, the eutectic structure is a structure unique to an eutectic alloy, and is a structure in which two types of crystal phases are simultaneously crystallized from a liquid phase at a specific temperature to form a very fine metal structure. In this case, the eutectic structure is formed at a constant compositional ratio, and when a deviation occurs in the compositional ratio, one type of crystals are crystallized first and generally grow coarsely. When the composition deviates from the composition of the ideal eutectic structure, the crystals that are crystallized first and grow while being cooled from the liquidus temperature to the eutectic temperature are called primary crystals.

For example, in a case in which the AgSi alloy contains more Si than the composition of the ideal eutectic structure, the Si crystallizes as primary crystals, and the primary crystals of Si grow, and when the AgSi composition in the remaining liquid phase becomes the ideal composition, a fine eutectic structure begins to be formed for the first time. In such an alloy powder having an AgSi eutectic structure with more Si than the compositional ratio of the eutectic, primary Si crystals of about several micrometers are dispersed in the particles, and in the AgSi eutectic structure, Si is finely dispersed in Ag at a level of around 100 nm or less. In addition, in a case in which the AgSi alloy contains more Ag than the composition of the ideal eutectic structure, the Ag crystallizes as primary crystals, and the primary crystals of Ag grow, and when the AgSi composition in the remaining liquid phase becomes the ideal composition, a fine eutectic structure begins to be formed for the first time. The size of the primary crystals also varies depending on the size of the particle, but crystals having openings of several to 10-fold or more are observed in one particle, and among these, crystals having a large size can be identified as primary crystals.

The method for producing the alloy powder having the eutectic structure is not particularly limited, and the alloy powder can be produced, for example, by a method in which a mixture of silver (Ag) and silicon (Si) heated to a liquid state is pulverized by gas atomization or water atomization.

The proportion of the AgSi eutectic structure on the particle surface when the alloy powder is measured by the above-described method is more preferably 15% or more, and even more preferably 20% or more. When the proportion of the AgSi eutectic structure on the particle surface is 10% or more, silver (Ag) is recrystallized and exuded from the surface of the alloy powder during sinter bonding, and bonding strength can be sufficiently exhibited.

The linear expansion coefficient of the alloy powder, as measured with a thermomechanical analyzer (device name "TMA-60", available from Shimadzu Corporation), is preferably 17 or less, more preferably 13 or less, and even more preferably 11 or less. When the linear expansion coefficient is within the above range, connection reliability is easily exhibited.

Preferably, portions of the contact surfaces between the above-described alloy powders are bonded by recrystallized Ag, and more preferably, the entire contact surfaces are bonded by recrystallized Ag. Excellent bonding reliability can be achieved by bonding a portion of the contact surfaces thereof by crystallized Ag.

The content of silver (Ag) in the alloy powder is preferably from 15 to 97.6 mass%, more preferably from 20 to 90 mass%, and still more preferably from 30 to 80 mass%. When the content of silver (Ag) is 15 mass% or more, the proportion of the eutectic structure on the surface of the alloy powder can be made sufficient. In addition, when the content is 97.6 mass% or less, the linear expansion coefficient can be sufficiently lowered, and production costs can be kept low while bonding reliability is exhibited.

The content of silicon (Si) in the alloy powder is preferably from 2.4 to 85 mass%, more preferably from 10 to 80 mass%, and even more preferably from 20 to 70 mass%. When the content of silicon (Si) in the alloy powder is 2.4 mass% or more, the linear expansion coefficient can be kept sufficiently low, and production costs can be easily kept low while bonding reliability is exhibited. Moreover, when the content thereof is 85 mass% or less, the proportion of the eutectic structure on the surface of the alloy powder can be maintained at a sufficient level.

The alloy powder may contain other components in addition to silver (Ag) and silicon (Si), but from the viewpoint of obtaining an alloy powder that can operate at high temperatures and exhibits connection reliability while complying with environmental regulations, the alloy powder preferably does not contain components other than silver (Ag) and silicon (Si).

The total content of silver (Ag) and silicon (Si) in the alloy powder relative to the total amount of the alloy powder is preferably 90 mass% or more, more preferably 95 mass% or more, and still more preferably 100 mass%.

The average particle size (median diameter) of the alloy powder is preferably from 0.1 to 100 μm, more preferably from 0.5 to 50 μm, even more preferably from 0.7 to 10 μm, and particularly preferably from 1.0 to 3 μm. When the average particle size is 0.1 μm or more, handling is facilitated, and when the average particle size is 100 μm or less, the amount of surface area of the alloy powder becomes sufficient, and bonding is easily carried out in a short amount of time. The average particle size (median diameter) can be measured by a laser diffraction/scattering method.

The shape of the alloy powder is not particularly limited, and examples include a spherical shape, a flake shape (flat shape), and a polyhedral shape. Alloy powders of the same shape may be used alone, or alloy powders of different shapes may be used in combination. Of these, the alloy powder is preferably spherical.

An embodiment of the present disclosure is an alloy powder-containing composition containing the above-described alloy powder. The form of the alloy powder-containing composition is not particularly limited, and the composition may be in various forms. For example, an alloy powder-containing composition called an alloy ink can be prepared by dispersing the alloy powder in an appropriate organic solvent (dispersion medium) in a suspended state. Alternatively, an alloy powder-containing composition called an alloy paste can be prepared by dispersing the alloy powder in an organic solvent in a kneaded state. Among these, the alloy powder-containing composition is preferably an alloy paste.

Alloy Paste

The alloy paste preferably contains, in addition to the alloy powder, a below-described organic substance, metal particles other than the alloy powder, and the like. As the alloy powder contained in the alloy paste, one type may be used alone, or two or more types thereof may be used in combination.

The alloy paste preferably contains the organic substance. Moreover, as the organic substance, one type may be used alone, or two or more types thereof may be used in combination.

Examples of the organic substance include an organic solvent, a binder resin, and an additive.

The abovementioned organic solvent preferably includes at least an organic solvent (a), an organic solvent (b), and an organic solvent (c). The organic solvent (a), the organic solvent (b), and the organic solvent (c) are different compounds and satisfy Expressions (1) to (6) below. Only one type of each of the organic solvent (a), the organic solvent (b), and the organic solvent (c) may be used, or two or more types thereof may be used.

$$150°C \leq Ta \leq 250°C \quad (1)$$

$$150°C \leq Tb \leq 250°C \quad (2)$$

$$250°C \leq Tc \leq 350°C \quad (3)$$

$$\delta a \geq 10.0 \quad (4)$$

$$\delta c \leq 9.0 \quad (5)$$

$$\delta c \leq \delta b \leq \delta a \quad (6)$$

In the expressions, Ta to Tc represent the boiling points of the organic solvents (a) to (c), respectively, and δa to δc represent the Hansen solubility parameters of the organic solvents (a) to (c), respectively. In the present specification, the Hansen solubility parameter may be referred to as "SP value" and described as "δ".

The organic solvents (a) to (c) only need to be uniformly dissolved to form a liquid state when mixed at a blending ratio used in the bonding conductive paste, and each of them may be in a liquid state or a solid state at room temperature by itself.

The organic solvent (a) satisfies at least Expression (1). That is, the boiling point Ta of the organic solvent (a) satisfies 150°C ≤ Ta ≤ 250°C, preferably satisfies 150°C < Ta < 250°C, more preferably satisfies 155°C ≤ Ta ≤ 220°C, and even more preferably satisfies 160°C ≤ Ta ≤ 200°C. When the organic solvent (a) having a boiling point within the above range is used, the organic solvent is easily volatilized during sintering, and a sintered compact can be easily formed.

The organic solvent (a) satisfies at least Expression (4) [δa ≥ 10.0]. The SP value δa of the organic solvent (a) is 10.0 or more, preferably 10.3 or more, and more preferably 10.4 or more, as long as the SP value δa is within the range that satisfies Expression (6). When the δa is 10.0 or more, the dispersibility of the alloy powder and the below-described metal particles is excellent, and separation of the alloy powder and metal particles from the organic solvent does not easily occur. The δa of the organic solvent (a) is, for example, 16.0 or less and may be 15.0 or less.

Examples of the organic solvent (a) include an alcohol solvent, a urea-based solvent, and an aprotic polar solvent. Examples of the alcohol solvent include compounds having one or more hydroxy groups. Among them, a tertiary alcohol and an ether alcohol are preferred. The alcohol solvent may have two or more hydroxy groups. The ether alcohol is a compound having an ether bond and a hydroxy group, and examples thereof include a (poly)alkylene glycol monoalkyl ether and an alkoxy group-substituted alcohol.

Specific examples of the organic solvent (a) include pinacol (δ 10.7, boiling point 172°C), tetramethylurea (δ 10.6, boiling point 177°C), 3-methoxybutanol (δ 10.6, boiling point 161°C), 1-methylcyclohexanol (δ 10.4, boiling point 155°C), and methyl carbitol (diethylene glycol monomethyl ether) (δ 10.7, boiling point 193°C).

The organic solvent (b) satisfies at least Expression (2). That is, the boiling point Tb of the organic solvent (b) satisfies 150°C ≤ Tb ≤ 250°C, preferably satisfies 150°C < Tb < 250°C, more preferably satisfies 180°C ≤ Tb ≤ 248°C, and even more preferably satisfies 200°C ≤ Tb ≤ 245°C. When the organic solvent (b) having a boiling point within the above range is used, the organic solvent is easily volatilized during sintering, and a sintered compact can be easily formed. When the organic solvent (b) having a boiling point of 250°C or lower is used, void generation during sintering can be suppressed.

The organic solvent (b) satisfies at least Expression (6). The SP value δb of the organic solvent (b) is preferably from 8.0 to 12.0, more preferably from 8.5 to 11.0, and even more preferably from 9.0 to 10.5, as long as the SP value δb is within the range that satisfies Expression (6). When the δb is within the above range, there is a tendency that the miscibility between the organic solvent (a) and the organic solvent (c) is improved, separation is less likely to occur, and continuous discharge stability and storage stability are more excellent.

Examples of the organic solvent (b) include an alcohol solvent, an ester solvent, a ketone solvent, and an amine-based solvent. Examples of the alcohol solvent include solvent compounds having one or more hydroxy groups. Among them, a tertiary alcohol, an ether alcohol, and an ester alcohol are preferred. The ether alcohol is a compound having an ether bond and a hydroxy group, and examples thereof include a (poly)alkylene glycol monoalkyl ether and an alkoxy group-substituted alcohol. The ester alcohol is a compound having an ester bond and a hydroxy group, and examples thereof include a (poly)alkylene glycol monoalkyl ether monoester. Examples of the ester solvent include diacetates of diols such as (poly)alkylene glycols. The ketone solvent is preferably a cyclic ketone. The amine-based solvent is preferably an alkylamine.

The organic solvent (b) is selected on the premise that it satisfies Expression (6) in the relationship with the organic solvents (a) and (c). Specific examples of the organic solvent (b) that can be used include d-Camphor (camphor) ($\delta$ 10.4, boiling point 204°C), 1-heptanol ($\delta$ 10.0, boiling point 177°C), butyl carbitol (diethylene glycol monobutyl ether) ($\delta$ 10.2, boiling point 231°C), ethyl carbitol (diethylene glycol monoethyl ether) ($\delta$ 10.5, boiling point 196°C), tripropylene glycol monomethyl ether ($\delta$ 9.4, boiling point 243°C), $\alpha$-terpineol ($\delta$ 9.3, boiling point 220°C), dihydroterpineol ($\delta$ 9.0, boiling point 210°C), 1,3-butanediol diacetate ($\delta$ 9.2, boiling point 232°C), propylene glycol diacetate ($\delta$ 9.3, boiling point 190°C), butyl carbitol acetate ($\delta$ 9.0, boiling point 247°C), dipropylene glycol butyl ether ($\delta$ 9.2, boiling point 230°C), isophorone ($\delta$ 9.5, boiling point 213°C), 1-decanol ($\delta$ 9.6, boiling point 230°C), propylene glycol monobutyl ether ($\delta$ 9.0, boiling point 170°C), and 1-nonanol ($\delta$ 9.8, boiling point 214°C).

Preferably, the boiling point Tb of the organic solvent (b) is higher than the boiling point Ta of the organic solvent (a), that is, Tb > Ta. The temperature difference between Tb and Ta [Tb - Ta] is preferably 2°C or more, more preferably 5°C or more, and even more preferably 10°C or more. When the temperature difference is 2°C or more, void generation during sintering can be further suppressed.

The organic solvent (c) satisfies at least Expression (3). That is, the boiling point Tc of the organic solvent (c) satisfies 250°C $\leq$ Tc $\leq$ 350°C, preferably satisfies 250°C < Tc < 350°C, more preferably satisfies 250°C < Tc $\leq$ 320°C, and even more preferably satisfies 250°C < Tc $\leq$ 300°C. When the organic solvent (c) having a boiling point within the above range is used, rapid volatilization of the organic solvent (a) and the organic solvent (b) and void generation can be suppressed during sintering.

The organic solvent (c) satisfies at least Expression (5) [$\delta c \leq 9.0$]. The SP value $\delta c$ of the organic solvent (c) is 9.0 or less, preferably 8.7 or less, and more preferably 8.5 or less. When the $\delta c$ is 9.0 or less, void generation during sintering can be suppressed. The $\delta c$ of the organic solvent (c) is, for example, 6.0 or more and may be 7.0 or more.

Examples of the organic solvent (c) include an ether solvent, an alkane solvent, and an ester solvent. Examples of the ether solvent include (poly)alkylene glycol dialkyl ether. The alkane solvent is preferably an alkane having 14 or more carbon atoms (for example, from 14 to 20 carbon atoms). Examples of the ester solvent include esters of (poly)alkylene glycol alkyl ethers and fatty acids.

Specific examples of the organic solvent (c) include dibutyl carbitol (diethylene glycol dibutyl ether) ($\delta$ 8.3, boiling point 255°C), tetradecane ($\delta$ 7.9, boiling point 254°C), and hexadecane ($\delta$ 8.0, boiling point 287°C).

Preferably. the boiling point Tc of the organic solvent (c) is higher than the boiling point Tb of the organic solvent (b), that is, Tc > Tb. The temperature difference between Tc and Tb [Tc - Tb] is preferably 2°C or more, more preferably 6°C or more, and even more preferably 10°C or more. When the temperature difference is 2°C or more, void generation during sintering can be further suppressed.

Preferably, the boiling point Tc of the organic solvent (c) is higher than the boiling point Ta of the organic solvent (a), that is, Tc > Ta. The temperature difference between Tc and Ta [Tc - Ta] is preferably 30°C or more, more preferably 50°C or more, and even more preferably 60°C or more. When the temperature difference is 30°C or more, void generation during sintering can be further suppressed.

The relationship among the SP value $\delta a$ of the organic solvent (a), the SP value $\delta b$ of the organic solvent (b), and the SP value $\delta c$ of the organic solvent (c) satisfies Expression (6) [$\delta c \leq \delta b \leq \delta a$] above. In particular, preferably, $\delta b$ is preferably higher than $\delta c$, that is, $\delta c < \delta b$ is satisfied. In addition, preferably, $\delta a$ is higher than $\delta b$, that is, $\delta b < \delta a$ is satisfied.

The difference between $\delta b$ and $\delta c$ [$\delta b - \delta c$] is preferably 0.1 or more, more preferably 0.2 or more, and even more preferably 0.5 or more. When the difference is 0.1 or more, the dispersibility of the metal particles is more excellent, and the continuous discharge stability is more excellent. The difference is preferably 2.0 or less, more preferably 1.5 or less, and even more preferably 1.3 or less. When the above difference is 2.0 or less, the alloy powder and metal particles are not easily separated from the organic solvent, and the continuous discharge stability and the storage stability are more excellent.

The difference between $\delta a$ and $\delta b$ [$\delta a - \delta b$] is preferably 0.1 or more, more preferably 0.2 or more, and even more preferably 0.5 or more. When the difference is 0.1 or more, the dispersibility of the metal particles is more excellent, and the continuous discharge stability is more excellent. The difference is preferably 2.5 or less, more preferably 2.0 or less, and even more preferably 1.8 or less. When the above difference is 2.5 or less, the alloy powder and the metal particles do not easily separate from the organic solvent, and the continuous discharge stability and the storage stability are more excellent.

The difference between δa and δc [δa - δc] based on Expressions (4) and (5) is 1.0 or more, preferably 1.5 or more, and more preferably 2.0 or more. When the difference is 1.0 or more, void generation during sintering can be further suppressed. The difference is preferably 5.0 or less, more preferably 4.0 or less, and even more preferably 3.0 or less. When the above difference is 5.0 or less, the alloy powder and the metal particles do not easily separate from the organic solvent, and the continuous discharge stability and the storage stability are more excellent.

The proportion of the organic solvent (a) relative to 100 mass% of the total amount of the organic solvent (a), the organic solvent (b), and the organic solvent (c) [organic solvent (a)/{organic solvent (a) + organic solvent (b) + organic solvent (c)}] is preferably from 5 to 70 mass%, more preferably from 10 to 60 mass%, and even more preferably from 15 to 50 mass%. When the proportion is within the above range, the organic solvent is easily volatilized during sintering, a sintered compact can be easily formed, and the dispersibility of the alloy powder and the metal particles is more excellent.

The proportion of the organic solvent (b) relative to 100 mass% of the total amount of the organic solvent (a), the organic solvent (b), and the organic solvent (c) [organic solvent (b)/{organic solvent (a) + organic solvent (b) + organic solvent (c)}] is preferably from 5 to 70 mass%, more preferably from 10 to 60 mass%, and even more preferably from 15 to 50 mass%. When the proportion is within the above range, the miscibility among the organic solvents is excellent, and continuous discharge stability and storage stability are more excellent.

The proportion of the organic solvent (c) relative to 100 mass% of the total amount of the organic solvent (a), the organic solvent (b), and the organic solvent (c) [organic solvent (c)/{organic solvent (a) + organic solvent (b) + organic solvent (c)}] is preferably from 5 to 70 mass%, more preferably from 10 to 60 mass%, and even more preferably from 15 to 50 mass%. When the proportion is within the above range, void generation during sintering can be further suppressed.

The content of the organic solvent (c) relative to 100 parts by mass of the organic solvent (a) is preferably from 20 to 400 parts by mass, more preferably from 30 to 300 parts by mass, and even more preferably from 50 to 200 parts by mass. When the content is within the above range, the blending amounts of the organic solvent (a) and the organic solvent (c) are well balanced, and void suppression during sintering and the dispersibility of the alloy powder and metal particles are further improved.

The content of the organic solvent (b) relative to 100 parts by mass of the total amount of the organic solvent (a) and the organic solvent (c) is preferably from 10 to 200 parts by mass, more preferably from 20 to 150 parts by mass, and even more preferably from 40 to 100 parts by mass. When the content is within the above range, the miscibility between the organic solvent (a) and the organic solvent (c) is further improved, and continuous discharge stability and low-temperature storage property are more excellent.

The organic solvent may contain an additional solvent (organic solvent) besides the organic solvent (a), the organic solvent (b), and the organic solvent (c). The total content proportion of the organic solvent (a), the organic solvent (b), and the organic solvent (c) in the organic solvent is preferably 50 mass% or more, more preferably 70 mass% or more, even more preferably 80 mass% or more, still more preferably 90 mass% or more, and particularly preferably 95 mass% or more, relative to 100 mass% of the total amount of the organic solvent. When the content proportion is 50 mass% or more, the dispersibility of the metal particles and the miscibility among the organic solvents are more excellent, and the continuous discharge stability, the storage stability, and the suppression of void generation during sintering are more excellent.

When the organic solvent (a), the organic solvent (b), and the organic solvent (c) are mixed in a blending ratio used in the bonding conductive paste, it is preferable that the organic solvent (a), the organic solvent (b), and the organic solvent (c) are homogeneously dissolved at ordinary temperature and do not cause phase separation. In the bonding conductive paste, it is preferable that the organic solvent (a), the organic solvent (b), and the organic solvent (c) are homogeneously dissolved at ordinary temperature and do not cause phase separation. In particular, the organic solvents preferably do not cause phase separation at 22 to 28°C (preferably at 10 to 30°C and more preferably at 0 to 35°C).

Specific examples of the abovementioned binder resin include vinyl chloride-vinyl acetate copolymers, polyvinyl butyral resins, polyester resins, acrylic resins, and cellulosic resins (for example, ethyl cellulose).

Examples of the additives include a surface modifier, a viscosity modifier, a dispersant, and a defoaming agent.

The content of the organic substance in the alloy paste per 100 parts by mass of the total of the alloy powder and the metal particles other than the alloy powder is preferably from 0.5 to 50 parts by mass, more preferably from 0.7 to 30 parts by mass, and still more preferably from 1 to 12 parts by mass.

Moreover, the alloy paste preferably contains, in addition to the alloy powder, metal particles other than the alloy powder. Among these metal particles, silver (Ag) particles are preferable because silver particles can be strongly bonded to the silver (Ag) contained in the AgSi eutectic structure in the alloy powder.

The average particle size (median diameter) of the metal particles other than the alloy powder is preferably from 0.1 to 100 μm, more preferably from 0.3 to 50 μm, and even more preferably from 0.5 to 10 μm. When the average particle size is 0.1 μm or more, the metal particles are easily handled. In addition, bonding reliability is easily exhibited by setting the volume average particle size thereof to 100 μm or less.

The shape of the metal particles other than the alloy powder is not particularly limited, and examples thereof include a spherical shape, a flake shape (flat shape), and a polyhedral shape. Moreover, metal particles of the same shape may be used alone, or metal particles having different shapes may be used in combination. Among these, the shape of the metal particles other than the alloy powder is preferably spherical in order to be appropriately disperse the metal particles in the alloy paste.

The content of the metal particles other than the alloy powder per 100 parts by mass of the alloy powder is preferably from 5 to 2000 parts by mass, more preferably from 10 to 1000 parts by mass, still more preferably from 20 to 500 parts by mass, and particularly preferably from 40 to 400 parts by mass. When the content of the metal particles other than the alloy powder is 5 parts by mass or more, the metal particles other than the alloy powder can be sufficiently bonded to the alloy powder during sinter bonding, and when the content of the metal particles other than the alloy powder is 2000 parts by mass or less, the linear expansion coefficient can be easily reduced.

The alloy paste may include other components in addition to the components described above. Examples of the other components include a surfactant other than the organic substance, and a viscosity modifier other than the organic substance. relative to the total amount of the organic substance, the content of the other components is preferably 5 mass% or less, and may be 3 mass% or less.

Semiconductor Device

An embodiment of the present disclosure is a semiconductor device in which the alloy powder-containing composition (preferably the alloy paste) is used as a bonding layer for bonding a substrate and an object to be bonded. In the semiconductor device, the object to be bonded is bonded to the substrate via a bonding layer, which is a sintered compact of the alloy powder-containing composition. FIG. 3 is a cross-sectional view schematically showing the semiconductor device. Reference numeral 1 denotes the semiconductor device, 10 denotes the substrate, 20 denotes the bonding layer, and 30 denotes the object to be bonded.

Examples of the substrate include metal substrates such as a copper substrate, ceramic substrates, metal-clad ceramic substrates, SiC substrates, gallium nitride substrates, glass-epoxy substrates, BT resin substrates, glass substrates, and resin substrates. Since the alloy paste according to one embodiment of the present disclosure can be sintered at a low temperature, a substrate that is weak against heat can also be used. The substrate is preferably a ceramic substrate or a metal-clad ceramic substrate, and is more preferably a copper-clad ceramic substrate or an aluminum-clad ceramic substrate.

Examples of the object to be bonded include an electronic component and a heat dissipation substrate. Examples of the electronic component include electronic elements (chips, dies) such as a semiconductor element and an LED element, and a specific example of the semiconductor element is a power semiconductor element. The bonded face of the object to be bonded with the bonding layer is preferably silver-plated. Examples of the material of the object to be bonded include Si (silicon), SiC (silicon carbide), GaN, and diamond.

The semiconductor device can be produced by applying the alloy powder-containing composition to a substrate by a printing method (specifically, dispenser printing, mask printing, screen printing, inkjet printing, or the like), placing, on the coating layer, an object to be bonded, and then sintering.

The sintering temperature is, for example, preferably from 150°C to 300°C, more preferably from 160 to 280°C, even more preferably from 200 to 270°C, and particularly preferably from 230 to 260°C. The sintering time is, for example, preferably from 0.5 minutes to 2 hours, more preferably from 10 minutes to 1 hour, and further preferably from 3 minutes to 10 minutes.

The thickness of the bonding layer formed by the above method is preferably from 3 μm to 500 μm, more preferably from 10 to 300 μm, and still more preferably from 40 to 150 μm.

Through the above sintering process, silver (Ag) present in the AgSi eutectic structure of the alloy powder in the alloy powder-containing composition is recrystallized and exuded, whereby silver (Ag) can be firmly bonded to the substrate and the object to be bonded. Further, since the bonding layer contains the alloy powder having a low linear expansion coefficient, the thermal expansion rate can be suppressed to a low level while the strength of the bonding portion is increased. Thus, properties such as thermal fatigue resistance of the bonding layer can be essentially improved. Accordingly, a semiconductor device in which the alloy powder-containing composition is used as a bonding layer for bonding a substrate and an object to be bonded can operate at high temperatures and exhibit excellent bonding reliability while complying with environmental regulations.

Each aspect disclosed in the present specification can be combined with another feature disclosed in the present specification. Moreover, each of the configurations, combinations thereof, and the like in each of the embodiments are merely examples, and various additions, omissions, and other changes of the configurations may be made, as appropriate, without departing from the scope of the present disclosure. The present disclosure is not limited by the embodiments and is limited only by the claims.

## Example

An embodiment of the present disclosure will be described in more detail below based on Examples.

### Example 1

Silver (Ag) ore (purity: 99.99%) and silicon (Si) ore (purity: 99.9999%) were mixed so as to have respective contents of 95 mass% and 5 mass%, and the mixture was heated at 1450°C and melted. The obtained solution was formed into a powder using a gas atomizing device (trade name "RQP-20K", available from Makabe R&D Co., Ltd.), and an alloy powder of Example 1 was obtained. The alloy powder was then atomized using a gas atomizing device and then classified using an ultrasonic vibration sieve (trade name "TSK-DGS", available from Tokyo Screen Co., Ltd.), and particles having an average particle size of 15.86 μm were obtained. The powder particle size was further adjusted using a high-speed rotary classifier (trade name "Turbo Classifier TC-15", available from Nisshin Engineering Inc.), and powder particles having an average particle size of 3.2 μm were obtained. The linear expansion coefficient of the alloy powder of Example 1 measured by a thermomechanical analyzer (device name "TMA-60", available from Shimadzu Corporation) was 16.42. The actual measurement result was 14.1 ppm.

### Examples 2 to 5

Alloy powders of Examples 2 to 5 were prepared in the same manner as in Example 1 with the exception that the content of the silver (Ag) particles and the content of the silicon (Si) particles were changed to the amounts described in Table 1. The average particle sizes and the linear expansion coefficients of Examples 2 to 5 were as indicated in Table 1.

### Comparative Example 1

Silver (Ag) particles (average particle size: from 2.0 μm to 3.4 μm, linear expansion coefficient: 19.3 ppm /K) were used instead of the above alloy powder.

### Comparative Example 2

Instead of the alloy powder, a mixed powder containing 80 mass% of silver (Ag) particles and 20 mass% of silicon (Si) particles was used. As the average particle size of the mixed powder, Ag particles (with a particle size from 2.0 μm to 3.4 μm) and Si particles (D50 = 10 μm) were used. The linear expansion coefficient of the mixed powder of Comparative Example 2 was 16.73.

## Evaluation

The physical properties of the alloy powders, silver particles, and mixed powder of the above examples and comparative examples were evaluated, and the results are presented in Table 1. An entry of "-" in Table 1 indicates that the evaluation was not performed or could not be performed.

### (1) Proportion of Eutectic Structure on Particle Surface

The alloy powders of the examples were cured in an epoxy resin and polished to an extent that the particle cross section could be observed. Any 10 adjacent particles of an alloy powder were subjected to a method including selecting one particle from an image of a particle cross section, the image being captured by SEM at a magnification of from 2000 to 50000 times, measuring the total outer peripheral length of the particle and the length of an outer peripheral portion where the eutectic structure was present in a region from the outer periphery to a depth of 0.2 μm in a direction toward the center of the particle, and calculating a proportion of the length of the outer peripheral portion thereof to the total outer peripheral length as the proportion of the AgSi structure on the particle surface. The percentage of AgSi eutectic structures of particles corresponding to the eighth highest proportion was recorded. It should be noted that the portion of the particle that was evaluated as the eutectic structure was the portion other than the portion determined be to be primary crystals.

### (2) Recrystallization (Exudation)

The alloy powders, silver particles, and mixed powder of the examples and comparative examples were heated at 300°C for 30 minutes, 60 minutes, or 90 minutes, and captured by SEM at a magnification of 3000 times. In the captured images, particles having particle sizes of less than 3 μm, from 3 to 7 μm, from 7 to 12 μm, and more than 12 μm were

selected. Of the selected particles, particles for which the surface recrystallized and silver (Ag) exuded by 0.1 μm or more were evaluated as ◎, particles for which recrystallization (exudation) of silver (Ag) was confirmed were evaluated as ○, and particles for which exudation (recrystallization) was not confirmed were evaluated as ×.

(3) Bonding Strength Between Particles

Of the alloy powders, silver particles, and mixed powder of the examples and comparative examples, those for which the entire contact surface between powders was bonded by recrystallized Ag were evaluated as ◎, those for which a portion of the contact surface between powders was bonded were evaluated as ○, and those for which the contact surface between powders was not bonded were evaluated as ×.

[Table 1]

Table 1

| | | Example 1 | | | | Example 2 | | | | Example 3 | | | |
|---|---|---|---|---|---|---|---|---|---|---|---|---|---|
| Powder composition (wt%) | | Ag95Si5 | | | | Ag80Si20 | | | | Ag60Si40 | | | |
| Particle size (μm) | | Less than 3 | 3 to 7 | 7 to 12 | More than 12 | Less than 3 | 3 to 7 | 7 to 12 | More than 12 | Less than 3 | 3 to 7 | 7 to 12 | More than 12 |
| Linear expansion coefficient (ppm/K) | | 16.42 | | | | 10.64 | | | | 6.87 | | | |
| Proportion (%) of eutectic structure on particle surface | | 95 | | | | 41.34 | | | | 43.83 | | | |
| Recrystallization (exudation) | 30 min | ◎ | ◎ | ◎ | ○ | ◎ | ◎ | × | × | ◎ | × | × | × |
| | 60 min | ◎ | ◎ | ◎ | ◎ | ◎ | ◎ | ◎ | ○ | ◎ | ◎ | × | × |
| | 90 min | ◎ | ◎ | ◎ | ◎ | ◎ | ◎ | ◎ | ◎ | ◎ | ◎ | ○ | × |
| Bonding strength | | ○ | | | | ○ | | | | ○ | | | |

| | | Example 4 | | | | Example 5 | | | | Comparative Example 1 | | | | Comparative Example 2 | | | |
|---|---|---|---|---|---|---|---|---|---|---|---|---|---|---|---|---|---|
| Powder composition (wt%) | | Ag40Si60 | | | | Ag20Si80 | | | | Ag100 | | | | Ag80Si20 | | | |
| Particle size (μm) | | Less than 3 | 3 to 7 | 7 to 12 | More than 12 | Less than 3 | 3 to 7 | 7 to 12 | More than 12 | Less than 3 | 3 to 7 | 7 to 12 | More than 12 | Less than 3 | 3 to 7 | 7 to 12 | More than 12 |
| Linear expansion coefficient (ppm/K) | | 4.8 | | | | 3.49 | | | | 19.7 | | | | 10.64 | | | |
| Proportion (%) of eutectic structure on particle surface | | 35.14 | | | | 36.55 | | | | 0 | | | | 0 | | | |
| Recrystallization (exudation) | 30 min | × | × | × | × | × | × | × | × | - | - | - | - | × | × | × | × |
| | 60 min | ◎ | × | × | × | ◎ | × | × | × | - | - | - | - | × | × | × | × |
| | 90 min | ◎ | ○ | × | × | ◎ | ○ | × | × | - | - | - | - | × | × | × | × |
| Bonding strength | | ○ | | | | ○ | | | | ◎ | | | | × | | | |

It was confirmed that because the alloy powders of the examples were made of silver (Ag) and Si (silicon), the linear expansion coefficient was suppressed to a low level while the environmental regulations were complied with, the silver (Ag) was recrystallized by heating at 300°C, and the alloy powder was bonded by the exuded silver (Ag). On the other hand, it was confirmed that the linear expansion coefficient was high in the case of only silver (Ag) powder (Comparative Example 1). In addition, in the case of the mixed powder of silver (Ag) and Si (silicon), the linear expansion coefficient could be maintained at a low value, but bonding by exuded silver (Ag) was not confirmed, and the bonding reliability was poor.

Hereinafter, variations of the present disclosure will be described.

[Addendum 1]

An alloy powder having an AgSi eutectic structure,
a proportion of the AgSi eutectic structure being 10% or more in at least 8 or more of 10 particles when any 10 adjacent particles of the alloy powder are subjected to a method including selecting one particle from an image of a particle cross section, the image being captured by SEM at a magnification of from 2000 to 50000 times, measuring a total outer peripheral length of the particle and a length of an outer peripheral portion where the eutectic structure is present, the outer peripheral portion excluding a region where no eutectic structure is present in a region from an outer periphery to a depth of 0.2 μm in a direction toward a center of the particle, and calculating a proportion of the length of the outer peripheral portion thereof to the total outer peripheral length as the proportion of the AgSi structure on the particle surface.

[Addendum 2]

The alloy powder according to addendum 1, in which the proportion of the AgSi eutectic structure is 15% or more, and preferably 20% or more.

[Addendum 3]

The alloy powder according to addendum 1 or 2, in which a linear expansion coefficient measured by a thermomechanical analyzer is 17 or less.

[Addendum 4]

The alloy powder according to any one of addenda 1 to 3, in which a portion of a contact surface between alloy powders is bonded by recrystallized Ag.

[Addendum 5]

The alloy powder according to any one of addenda 1 to 4, in which the entire contact surface between alloy powders is bonded by recrystallized Ag.

[Addendum 6]

The alloy powder according to any one of addenda 1 to 5, in which the alloy powder has an average particle size (median diameter) of from 0.1 to 100 μm.

[Addendum 7]

The alloy powder according to any one of addenda 1 to 6, in which a shape of the alloy powder is spherical.

[Addendum 8]

The alloy powder according to any one of addenda 1 to 7, in which, relative to a total amount of the alloy powder, a content of silver (Ag) is from 15 to 97.6 mass%, and a content of silicon (Si) is from 2.4 to 85 mass%.

[Addendum 9]

The alloy powder according to any one of addenda 1 to 8, in which the alloy powder does not include a component other than silver (Ag) and silicon (Si).

[Addendum 10]

An alloy paste including the alloy powder described in any one of addenda 1 to 9.

[Addendum 11]

The alloy paste according to addendum 10, further including an organic substance.

[Addendum 12]

The alloy paste according to addendum 11, in which the organic substance is an organic solvent.

[Addendum 13]

The alloy paste according to any one of addenda 10 to 12, further including metal particles other than the alloy powder, and a content of the metal particles other than the alloy powder being from 5 to 2000 parts by mass per 100 parts by mass of the alloy powder.

[Addendum 14]

The alloy paste according to any one of addenda 10 to 13, in which a content of the organic substance is from 0.5 to 50 parts by mass per 100 parts by mass of a total of the alloy powder and the metal particles other than the alloy powder.

[Addendum 15]

A semiconductor device including the alloy paste described in any one of addenda 10 to 14, the alloy paste being used as a bonding layer for bonding a substrate and an object to be bonded.

Reference Signs List

1 Semiconductor device
10 Substrate
20 Bonding layer
30 Object to be bonded

## Claims

1. An alloy powder comprising an AgSi eutectic structure,
wherein a proportion of the AgSi eutectic structure is 10% or more in at least 8 or more of 10 particles when any 10 adjacent particles of the alloy powder are subjected to a method including selecting one particle from an image of a particle cross section, the image being captured by SEM at a magnification of from 2000 to 50000 times, measuring a total outer peripheral length of the particle and a length of an outer peripheral portion where the eutectic structure is present, a region where no eutectic structure is present in a region from an outer periphery to a depth of 0.2 μm in a direction toward a center of the particle being excluded from the outer peripheral portion, and calculating a proportion of the length of the outer peripheral portion thereof to the total outer peripheral length as the proportion of the AgSi structure on the particle surface.

2. The alloy powder according to claim 1, wherein the alloy powder has an average particle size (median diameter) of from 0.1 to 100 μm.

3. The alloy powder according to claim 1 or 2, wherein, relative to a total amount of the alloy powder, a content of silver (Ag) is from 15 to 97.6 mass%, and a content of silicon (Si) is from 2.4 to 85 mass%.

4. An alloy paste comprising the alloy powder described in claim 1 or 2.

**5.** An alloy paste comprising the alloy powder described in claim 3.

**6.** The alloy paste according to claim 4, further comprising an organic substance.

**7.** The alloy paste according to claim 4, further comprising metal particles other than the alloy powder, a content of the metal particles other than the alloy powder being from 5 to 2000 parts by mass per 100 parts by mass of the alloy powder.

**8.** A semiconductor device comprising the alloy paste described in claim 4, the alloy paste being used as a bonding layer for bonding a substrate and an object to be bonded.

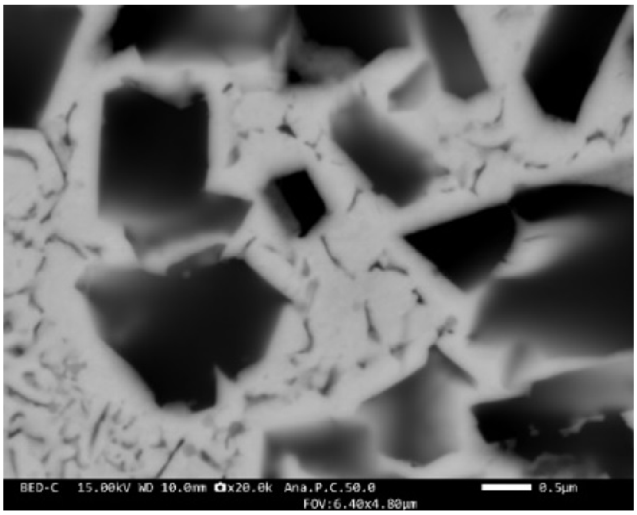


FIG. 1

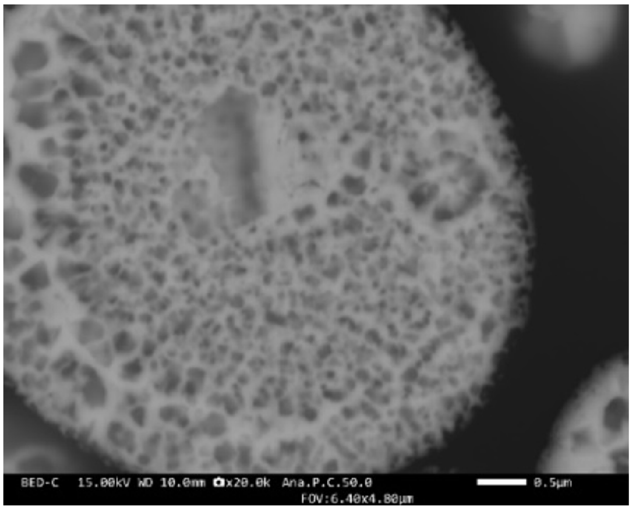


FIG. 2

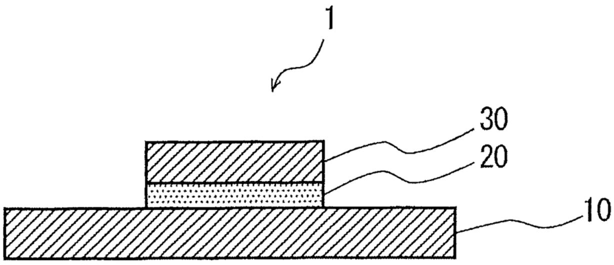


FIG. 3

**INTERNATIONAL SEARCH REPORT**

International application No.
**PCT/JP2024/031633**

**A. CLASSIFICATION OF SUBJECT MATTER**

***B22F 1/00***(2022.01)i; ***B22F 1/052***(2022.01)i; ***B22F 7/08***(2006.01)i; ***B22F 9/00***(2006.01)i; ***C22C 5/06***(2006.01)i; ***H01L 21/52***(2006.01)i
FI: B22F1/00 K; B22F1/052; B22F7/08 C; B22F9/00 B; C22C5/06 Z; H01L21/52 E

According to International Patent Classification (IPC) or to both national classification and IPC

**B. FIELDS SEARCHED**

Minimum documentation searched (classification system followed by classification symbols)

B22F1/00; B22F1/052; B22F7/08; B22F9/00; C22C5/06; H01L21/52

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2015-218372 A (MITSUBISHI ELECTRIC CORPORATION) 07 December 2015 (2015-12-07) paragraphs [0010], [0016], [0019]-[0021] | 1-3 |
| A | WO 2021/039874 A1 (DAICEL CORP.) 04 March 2021 (2021-03-04) paragraphs [0038], [0062], [0063], [0066] | 1-8 |

☐ Further documents are listed in the continuation of Box C.
☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **02 October 2024** | **15 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/031633**

| Patent document cited in search report | Publication date (day/month/year) | Patent family member(s) | Publication date (day/month/year) |
|---|---|---|---|
| JP 2015-218372 A | 07 December 2015 | (Family: none) | |
| WO 2021/039874 A1 | 04 March 2021 | TW 202126404 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2023146495 A
- JP 2003311469 A
- JP 2020069517 A
- JP 2019056158 A